# EUROPEAN PATENT SPECIFICATION

(11) **EP 1 444 379 B1**
(45) Date of publication and mention of the grant of the patent: **04.05.2005**
(21) Application number: 02801694.7
(22) Date of filing: 15.10.2002
(51) Int. Cl.: C23C 16/44, C23C 16/455

(54) **ATOMIC LAYER DEPOSITION APPARATUS AND PROCESS**
VORRICHTUNG UND VERFAHREN ZUR ABSCHEIDUNG VON ATOMAREN SCHICHTEN
APPAREIL ET PROCEDE D'AMELIORATION DU FONCTIONNEMENT D'UNE CHAMBRE DE DEPOT D'UNE COUCHE ATOMIQUE

(30) Priority: 15.10.2001 US 977612; 11.06.2002 US 166902; 08.07.2002 US 190792
(43) Date of publication of application: 11.08.2004
(73) Proprietor: MICRON TECHNOLOGY, INC., Boise, ID 83706-9632 (US)
(72) Inventor: CAMPBELL, Philip, H., Meridian, ID 83642 (US); KUBISTA, David, J., Nampa, ID 83686 (US)
(74) Representative: Crease, Devanand John
(86) International application number: PCT/US2002/032741
(87) International publication number: WO 2003/033762

(56) References cited:
- EP-A- 0 651 432
- US-A- 5 250 323
- US-A- 5 601 651
- US-A- 5 674 563
- US-B1- 6 270 572
- PATENT ABSTRACTS OF JAPAN vol. 013, no. 481 (E-838), 31 October 1989 (1989-10-31) & JP 01 189114 A (NEC CORP), 28 July 1989 (1989-07-28)
- PATENT ABSTRACTS OF JAPAN vol. 015, no. 090 (E-1040), 5 March 1991 (1991-03-05) & JP 02 304916 A (NEC CORP), 18 December 1990 (1990-12-18)
- PATENT ABSTRACTS OF JAPAN vol. 015, no. 139 (E-1053), 9 April 1991 (1991-04-09) -& JP 03 019211 A (FUJITSU LTD), 28 January 1991 (1991-01-28)
- PATENT ABSTRACTS OF JAPAN vol. 017, no. 340 (E-1389), 28 June 1993 (1993-06-28) & JP 05 047665 A (FUJITSU LTD), 26 February 1993 (1993-02-26)

## Description

The present invention relates to atomic layer deposition. More specifically, the present invention relates to an apparatus and process for improving the performance of an atomic layer deposition chamber.

A method of depositing very thin films is atomic layer deposition (ALD). This method has several advantages over tradition chemical vapor deposition. It can be performed at lower temperatures, uses a wide range of precursors, produces very thin films, inherently obtains 100% step coverage, and can be used to "microengineer" complex film matrices.

The following U.S. patents and published international patent application disclose a reaction chamber for processing thin films used in the semiconductor industry: U.S. Patent No. 5,674,563 to Tarui et al., European Patent Application Publication No. EP 0 651 432 A1, and U.S. Patent No. 6,270,572 B1 to Kim et al.

In ALD, individual precursors are pulsed onto the surface of a wafer in a sequential manner, without mixing the precursors in the gas phase. Each individual precursor reacts with the surface to form an atomic layer in a way that only one layer can form at a time. The surface reaction occurs such that the reaction is complete, and permits no more than one layer at a time to be deposited. This occurs no matter how many molecules are applied to the surface in an overdosing mode. The films are built up by introducing short bursts of gases in rapid cycles.

According to recognitions of the present inventors, two problems occur with the ALD method. One problem concerns the diversion of the flow of liquid precursors introduced in a vapor phase. During ALD processing using a liquid delivery system, it is necessary to keep an established flow of the liquid precursor in a vapor phase. In order to keep the flow active, the flow must be diverted to a fore-line of the ALD chamber when the liquid precursor is not needed in the deposition process. When the opposing gas is pulsed, the unreacted chemical is mixed in the fore-line with the diverted chemical and reacts causing a build up in the fore-line. The build up can be severe and clogs the fore-line. A second problem concerns the reaction of the gases. Process gases are introduced individually for the ALD process and disposed of through the same fore lines causing the gases or vapors to react with one another.

Accordingly, there is a need for an ALD apparatus and process that minimizes clogging of the fore-line of the diverted liquid precursor. There is also a need in the art to control any area that is common to the reactive gases or vapors in a way to minimize any unwanted reaction.

These needs are met by the present invention wherein an improved ALD apparatus and process are provided. The present invention fulfills the first need of minimizing clogging of the fore-line by providing an ALD apparatus and process that allows separate chemicals to only mix when and where desired by installing and monitoring a second fore-line. The present invention fulfills the second need of minimizing the reaction of the gases in the pump lines, by allowing the reactive gases or vapors to be removed from the process reactor chamber without coming in contact with one another in an area that would create an unwanted reaction of the process gases or vapors. This is accomplished by providing independent and dedicated pumping lines and corresponding isolation valves that are activated for the specific gas when needed. The separate pump lines allow the gas to be exhausted in a manner that minimizes possible unwanted reaction of the reactive gases. Accordingly, it is an object of the present invention to provide an improved ALD apparatus and process using dispensing fore-lines and a second exhaust path in order to prevent clogging of the exhaust fore-line.

The following detailed description of the preferred embodiments of the present invention can be best understood when read in conjunction with the following drawings, where like structure is indicated with like reference numerals and in which:
Figure 1 presents an illustration of an ALD apparatus according to one embodiment of the present invention;
Figure 2 presents an illustration of an ALD apparatus according to another embodiment of the present invention;
Figure 3 presents an illustration of an ALD apparatus according to still another embodiment of the present invention;
Figure 4 presents an illustration of an ALD apparatus according to yet another embodiment of the present invention; and
Figure 5 presents an illustration of an ALD apparatus according to yet another embodiment of the present invention.

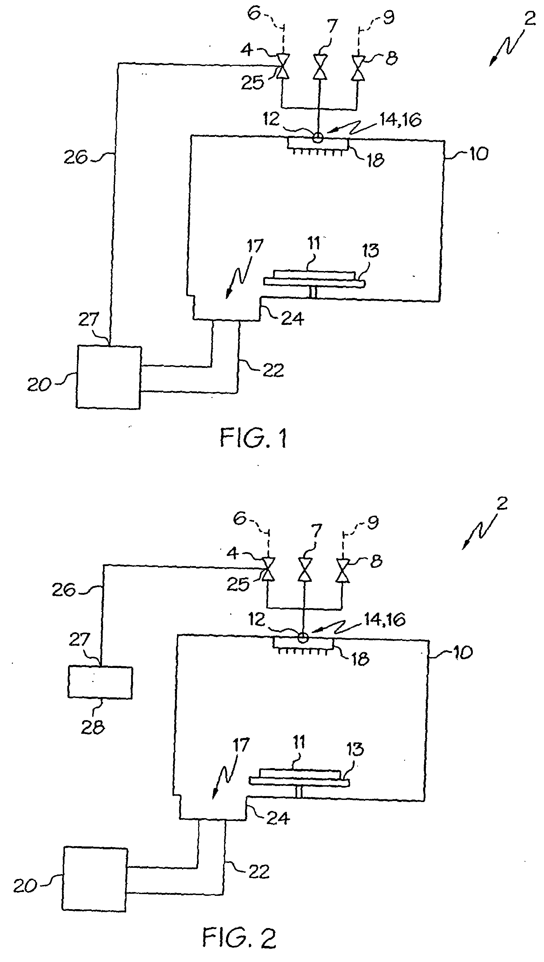

Referring initially to Fig. 1, an ALD apparatus 2 according to one embodiment of the present invention is illustrated. Fig. 1 illustrates an ALD apparatus 2 comprising a process reactor chamber **10**, a first dispensing valve **4**, a second dispensing value **8**, an isolation valve **24**, an exhaust fore-line **22**, an exhaust pump **20**, and a dispensing fore-line **26**. The process reactor chamber **10** includes a first precursor inlet **14**, a second precursor inlet **16**, and a first chamber outlet **17**. The first dispensing valve **4** is coupled to the first precursor inlet **14** of the process reactor chamber **10**. The second dispensing valve **8** is coupled to the second precursor inlet **16** of said process reactor chamber **10**. The isolation valve **24** is directly coupled to the first chamber outlet **17** of the process reactor chamber **10**. The exhaust pump **20** is coupled to the isolation valve **24** by the exhaust fore-line **22**, defining an exhaust path. The dispensing fore-line **26** comprises a first end **25** and a second end **27**. The first end **25** is coupled to the first dispensing valve **4** and the second end **27** is coupled to the exhaust pump **20**. As is illustrated in Fig. 1, no substantial exhaust fore-line exists between the isolation valve **24** and the first chamber outlet **17** because, as is noted above, the isolation valve **24** is directly coupled to the outlet **17**.

The first dispensing valve **4** allows a first precursor **6** to flow into the process reactor chamber **10** through a first precursor inlet **14**. A continuous flow of the first precursor **6** must be maintained. Therefore, the first dispensing valve **4** selectively diverts the direction of the first precursor **6** to the first precursor inlet **14** of the process reactor chamber **10**. When the first precursor **6** is not diverted into the process reactor chamber **10**, it is sent to the exhaust pump **20** via a dispensing fore-line **26**. The dispensing fore-line **26** is used to discard the first precursor **6** when it is not diverted into the first precursor inlet **14**. The dispensing fore-line **26** may be used to isolate the first precursor **6** from other chemicals, precursors, and exhausts that would otherwise mix with the first precursor **6** and potentially cause clogging of the first exhaust fore-line **22**. Thus, the exhaust fore-line **22** remains clean and flow remains stable and consistent.

The process reactor chamber **10** comprises a first precursor inlet **14**, a second precursor inlet **16**, a heater **13**, a wafer **11**, and a shower head device **18**. The first precursor inlet **14** and second precursor inlet **16** can share a common opening **12** or alternatively have separate openings. The first precursor inlet **14** may direct the first precursor **6** through a shower head device **18** that distributes the first precursor **6** into the process reactor chamber **10**. Once in the process reactor chamber **10** the first precursor **6** is absorbed onto the surface of a wafer **11**. The wafer rests on a heater **13**. The manner in which absorption of the precursor is achieved is beyond the scope of the present invention and is well known in the art. It may be gleaned from any one of a number of teachings relating to atomic layer deposition.

After the first precursor **6** is absorbed onto the wafer **11**, unreacted first precursor is purged out of the process reactor chamber **10** by introducing a purge gas via the purge valve **7** into the chamber outlet **17**. Unreacted first precursor flows directly into the isolation valve **24** where unreacted first precursor is transferred to the exhaust pump **20** via the exhaust fore-line **22**.

The first precursor **6** and second precursor **9** are introduced in separate intervals. Once unreacted first precursor is purged from the process reactor chamber **10** through use of the purging valve **7**, the second dispensing valve **8** allows for the introduction of the second precursor **9** into the second precursor inlet **16** and ultimately into the process reactor chamber **10**. The second precursor inlet **16** directs the second precursor **9** through a shower head device **18** that distributes the second precursor **9** into the process reactor chamber **10**. The second precursor **9** then reacts with the layer formed on the wafer **11** from the first precursor **6**, creating a monolayer of film on the wafer **11**.

Unreacted second precursor is purged from the process reactor chamber **10**, using the purging valve **7**, into the chamber outlet **17**. Unreacted second precursor flows directly into the isolation valve **24** where unreacted second precursor is transferred to the exhaust pump **20** via the exhaust fore-line **22**.

This process of the introduction, reaction, and purging alternating the first precursor **6** with the second precursor **9** is performed at a high rate of speed with continuous successions.

For the purposes of describing and defining the present invention, it is noted that the precise mechanism by which the molecules of the first precursor adhere to the surface of the semiconductor substrate is not the subject of the present invention. The mechanism is merely described herein as 'absorption.' The generic term 'absorption' is intended to cover absorption, adsorption, and any other similar mechanisms by which the precursor may form a monolayer upon the surface of the wafer **11**.

The embodiment of the present invention illustrated in Fig. 2 differs from Fig.1 in that it utilizes a dispensing pump **28**. In this embodiment, the first end **25** of the dispensing fore-line **26** is coupled to the dispensing valve **4**. The second end **27** of the dispensing fore-line **26** is coupled to the dispensing pump **28**. The dispensing pump **28** collects the undiverted first precursor **6** so that the undiverted first precursor **6** is isolated from other chemicals, precursors, and exhausts that would otherwise mix with the first precursor **6** and potentially cause clogging of the first exhaust fore-line **22**. Thus, the exhaust fore-line **22** remains clean and flow remains stable and consistent.

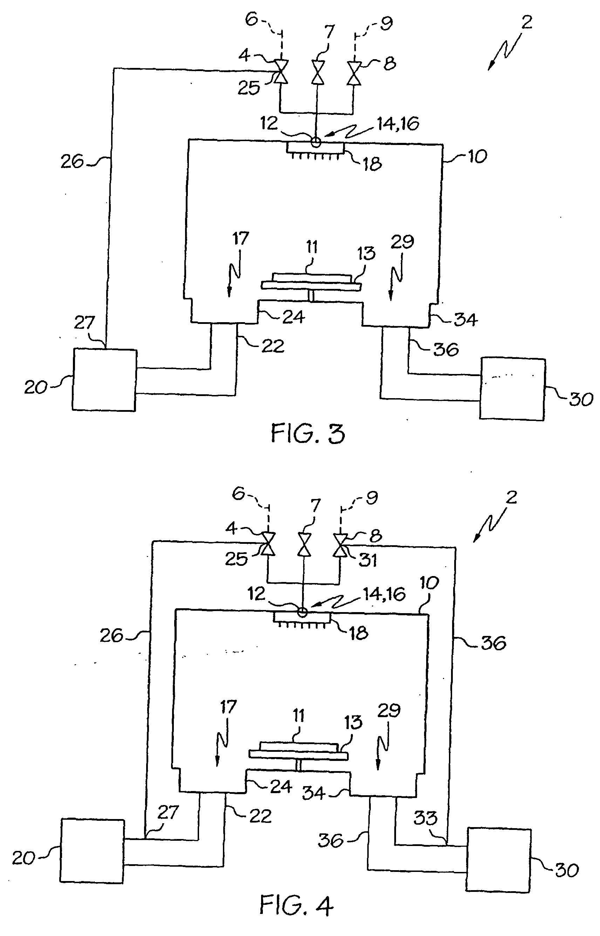

The embodiment of Fig. 3 differs from that illustrated in Fig. 2 because the second isolation valve **34**, the second exhaust fore-line **36**, and the second exhaust pump **30** are shown, thus defining a second exhaust path. This second exhaust path is constructed to keep the unreacted first precursor and the unreacted second precursor separate. Thereby, reducing the possibility of mixing and clogging the either of the exhaust fore-lines **22, 36**. The second isolation valve **34**, the second exhaust fore-line **36**, and the second exhaust pump **30** operate in a similar manner as the-first isolation valve **24**, the first exhaust fore-line **22**, and the first exhaust pump **20**. After the second precursor **9** is absorbed onto the wafer **11**, the unreacted second precursor is purged out of the process reactor chamber **10** by introducing a purge gas via the purge valve **7** into the second chamber outlet **29**. The unreacted second precursor flows directly into the second isolation valve **34** where the unreacted second precursor is transferred to the second exhaust pump **30** via the second exhaust fore-line **36**.

The embodiment in Fig. 3 also differs from that illustrated in Fig. 2 because the dispensing fore-line **26** is connected to the first exhaust path. Specifically, the dispensing fore-line **26** is connected to the first exhaust pump **20**. The dispensing valve could alternatively be coupled to the first exhaust fore-line **22** or directly to a dispensing pump **28** as illustrated in Fig. 2.

The embodiment of Fig. 4 differs from that of Fig. 3 because a second dispensing fore-line **36** is extended from the second dispensing valve **8** to the second exhaust path, specifically the second exhaust fore-line **33**. The second dispensing fore-line **36** can alternatively be directly connected to the second exhaust pump **30**, similar to the embodiment of Fig. 1 or connected to a second dispensing pump, similar to the embodiment of Fig. 2. The second dispensing pump would operate in a similar manner as the first dispensing pump **28** described above. The second dispensing pump collects the undiverted second precursor **9** so that the undiverted second precursor **9** is isolated from other chemicals, precursors, and exhausts that would otherwise mix with the second precursor **9** and potentially cause clogging of the second exhaust fore-line **36**. Thus, the second exhaust fore-line **36** remains clean and flow remains stable and consistent.

The second dispensing fore-line **36** operates in a similar manner as the first dispensing fore-line **26**. The second dispensing fore-line **36** is used to discard the second precursor **9** when it is not diverted into the second precursor inlet **16**. The second dispensing fore-line **36** may be used to isolate the second precursor **9** from other chemicals, precursors, and exhausts that would otherwise mix with the second precursor **9** and potentially cause clogging of the second exhaust fore-line **33**. Thus, the second exhaust fore-line **33** remains clean and flow remains stable and consistent.

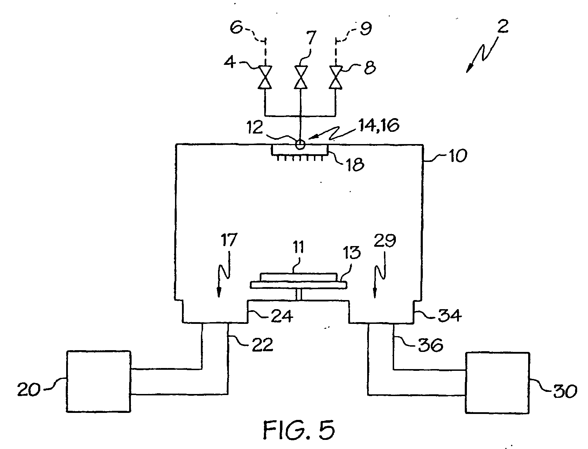

Fig. 5 differs from the previous figures because it does not show the first dispensing fore-line **26** or the second dispensing fore-line **36**. Therefore, only the two separate exhaust paths are depicted.

Having described the invention in detail and by reference to preferred embodiments thereof, it will be apparent that modifications and variations arc possible without departing from the scope of the invention defined in the appended claims. More specifically, although some aspects of the present invention are identified herein as preferred or particularly advantageous, it is contemplated that the present invention is not necessarily limited to these preferred aspects of the invention.

## Claims

1. An atomic layer deposition apparatus (2) comprising:
a process reactor chamber (10) comprising a first precursor inlet (14), a second precursor inlet (16), and a first chamber outlet (17);
a first dispensing valve (4) coupled to said first precursor inlet (14) of said process reactor chamber (10);
a second dispensing valve (8) coupled to said second precursor inlet (16) of said process reactor chamber (10);
a first exhaust path coupled to said process reactor chamber (10) configured to be selectively isolated from said process reactor chamber (10) by a first isolation valve (24) directly coupled to said chamber outlet (17) such that no substantial exhaust fore-line exists between said isolation valve (24) and said chamber outlet (17); and
a first dispensing fore-line (26) comprising a first end (25) and a second end (27), wherein said first end (25) is coupled to said first dispensing valve (4) and said second end (27) of said first dispensing fore-line (26) is coupled to said first exhaust path or a first dispensing pump (28).

2. An apparatus as claimed in claim 1, wherein said second end (27) of said first dispensing fore-line (26) is coupled to said first exhaust path.

3. An apparatus as claimed in claim 1, wherein said first exhaust path further comprises a first exhaust pump (20), said first isolation valve (24), and a first exhaust fore-line (22), wherein said first exhaust pump (20) is coupled to said first isolation valve (24) by said first exhaust fore-line (22).

4. An apparatus as claimed in claim 3, wherein said first exhaust path is isolated from said process reactor chamber (10) when said first isolation valve (24) is in a closed state.

5. An apparatus as claimed in claim 3, wherein said second end (27) of said first dispensing fore-line (26) is coupled to said first isolation valve (24) of said first exhaust path.

6. An apparatus as claimed in claim 3, wherein said second end (27) of said first dispensing fore-line (26) is coupled to said first exhaust pump (20) of said first exhaust path.

7. An apparatus as claimed in claim 3, wherein said second end (27) of said first dispensing fore-line (26) is coupled to said first exhaust fore-line (22) of said first exhaust path.

8. An apparatus as claimed in claim 1, wherein said apparatus further comprises a second exhaust path coupled to a second chamber outlet (29).

9. An apparatus as claimed in claim 8, wherein:
said first exhaust path comprises a first exhaust pump (20), said first isolation valve (24), and a first exhaust fore-line (22), wherein said first exhaust pump (20) is coupled to said first isolation valve (24) by said first exhaust fore-line (22); and
said second exhaust path comprises a second exhaust pump (30), a second isolation valve (34), and a second exhaust fore-line (32), wherein said second exhaust pump (30) is coupled to said second isolation valve (34) by said second exhaust fore-line (32).

10. An apparatus as claimed in claim 8, wherein said second exhaust path is isolated from said process reactor chamber (10) when said isolation valve (34) is in a closed state.

11. An apparatus as claimed in claim 8, wherein said second isolation valve (34) is directly coupled to said second chamber outlet (29) of said process reactor chamber (10) such that no substantial exhaust fore-line exists between said second isolation valve (34) and said second chamber outlet (29).

12. An apparatus as claimed in claim 1, wherein said second end (27) of said first dispensing fore-line (26) is coupled to said first dispensing pump (28).

13. An apparatus as claimed in claim 1, wherein said apparatus further comprises a second dispensing fore-line (36) comprising a first end (31) and a second end (33), wherein said first end (31) is coupled to said second dispensing valve (8) and said second end (33) of said second dispensing fore-line (36) is coupled to a second exhaust path.

14. An apparatus as claimed in claim 13 wherein:
said first exhaust path comprises a first exhaust pump (20), said first isolation valve (24), and a first exhaust fore-line (22), wherein said first exhaust pump (20) is coupled to said first isolation valve (24) by said first exhaust fore-line (22); and
said second exhaust path comprises a second exhaust pump (30), a second isolation valve (34), and a second exhaust fore-line (32), wherein said second exhaust pump (30) is coupled to said second isolation valve (34) by said second exhaust fore-line (32).

15. An apparatus as claimed in claim 14, wherein said second end (33) of said second dispensing fore-line (36) is coupled to said second isolation valve (34) of said second exhaust path.

16. An apparatus as claimed in claim 14, wherein said second end (33) of said second dispensing fore-line (36) is coupled to said second exhaust pump (30) of said second exhaust path.

17. An apparatus as claimed in claim 14, wherein said second end (33) of said second dispensing fore-line (36) is coupled to said second exhaust fore-line (32) of said second exhaust path.

18. An apparatus as claimed in claim 12, wherein said apparatus further comprises a second dispensing fore-line (36) comprising a first end (31) and a second end (33), wherein said first end (31) is coupled to said second dispensing valve (8) and said second end (33) of said second dispensing fore-line (36) is coupled to a second dispensing pump.

19. An apparatus as claimed in claim 1, wherein said apparatus further comprises a first vapor supply coupled to said first precursor inlet (14).

20. An apparatus as claimed in claim 19, wherein said apparatus further comprises a second vapor supply coupled to said second precursor inlet (16).

21. An apparatus as claimed in claim 1, wherein said first precursor inlet (14) and said second precursor inlet (16) share a common opening.

22. An apparatus as claimed in claim 1, wherein said first precursor inlet (14) and said second precursor inlet (16) have separate openings.

23. An apparatus as claimed in claim 1, wherein said apparatus comprises a purging valve (7).

24. An apparatus as claimed in claim 1, wherein said process reactor chamber (10) further includes a shower head device (18).

25. An atomic layer deposition apparatus (2) comprising:
a process reactor chamber (10);
a first isolation valve (24) directly coupled to a first chamber outlet (17) of said process reactor chamber (10) such that no substantial exhaust fore-line exists between said first isolation valve (24) and said first chamber outlet (17);
a first exhaust pump (20) coupled to said first isolation valve (24) by a first exhaust fore-line (22);
a second isolation valve (34) directly coupled to a second chamber outlet (29) of said process chamber (10) such that no substantial exhaust fore-line exists between said second isolation valve (34) and said second chamber outlet (29); and
a second exhaust pump (30) coupled to said second isolation valve (34) by a second exhaust fore-line (32).

26. A process for atomic layer deposition comprising:
introducing a first precursor into a first precursor inlet (14) of a process reactor chamber (10);
controlling said process reactor chamber (10) for absorption of said first precursor onto a substrate;
purging said chamber (10) of unabsorbed first precursor by opening an isolation valve directly coupled to a chamber outlet such that no substantial exhaust fore-line exists between said isolation valve and said chamber outlet;
introducing a second precursor into a second precursor inlet (16) of said process reactor chamber (10);
controlling said process reactor chamber (10) for reaction of said second precursor with said first precursor; and
purging said process reactor chamber (10) of unreacted second precursor by opening an isolation valve directly coupled to a chamber outlet such that no substantial exhaust fore-line exists between said isolation valve and said chamber outlet.

27. A process as claimed in claim 26, wherein:
said process reactor chamber (10) is purged of said unabsorbed first precursor by opening a first isolation valve (24) directly coupled to a first exhaust outlet in said reactor chamber (10); and
said process reactor chamber (10) is purged of unreacted second precursor by opening a second isolation valve (34) directly coupled to a second exhaust outlet in said reactor chamber (10).

28. An atomic layer deposition apparatus (2) comprising:
a process reactor chamber (10) comprising a first precursor inlet (14), a second precursor inlet (16), and a first chamber outlet (17);
a first dispensing valve (4) coupled to said first precursor inlet (14) of said process reactor chamber (10);
a second dispensing valve (8) coupled to said second precursor inlet (16) of said process reactor chamber (10);
a first exhaust path coupled to said first chamber outlet (17) of said process reactor chamber (10) and configured to be selectively isolated from said process reactor chamber (10), wherein said first exhaust path comprises a first isolation valve (24), a first exhaust fore-line (22), and a first exhaust pump (20) coupled to said first isolation valve (24) by said first exhaust fore-line (22);
a second exhaust path coupled to a second chamber outlet (29) of said process reactor chamber (10) and configured to be selectively isolated from said process reactor chamber (10), wherein said second exhaust path comprises a second isolation valve (34), a second exhaust fore-line (32), and a second exhaust pump (30) coupled to said second isolation valve (34) by said second exhaust fore-line (32);
a first dispensing fore-line (26) comprising a first end (25) and a second end (27), wherein said first end (25) is coupled to said first dispensing valve (4) and said second end (27) of said first dispensing fore-line (26) is coupled to said first exhaust path (22) or a first dispensing pump (20); and
a second dispensing fore-line (36) comprising a first end (31) and a second end (33), wherein said first end (31) is coupled to said second dispensing valve (8) and said second end (33) of said second dispensing fore-line (36) is coupled to said second exhaust path or a second dispensing pump.

## Patentansprüche

1. Atomlagenabscheidungsvorrichtung (2), die folgendes umfaßt:
eine Prozeßreaktorkammer (10), die einen ersten Vorläufereinlaß (14), einen zweiten Vorläufereinlaß (16) und einen ersten Kammerauslaß (17) umfaßt;
ein erstes Ausgabeventil (4), das an den ersten Vorläufereinlaß (14) der Prozeßreaktorkammer (10) gekoppelt ist;
ein zweites Ausgabeventil (8), das an den zweiten Vorläufereinlaß (16) der Prozeßreaktorkammer (10) gekoppelt ist;
einen ersten Abzugsweg, der an die Prozeßreaktorkammer (10) gekoppelt ist, konfiguriert, um von der Prozeßreaktorkammer (10) durch ein erstes Trennventil (24) selektiv getrennt zu sein, direkt an den Kammerauslaß (17) gekoppelt, so daß keine wesentliche Abzugsvorleitung zwischen dem Trennventil (24) und dem Kammerauslaß (17) existiert; und
eine erste Ausgabevorleitung (26), die ein erstes Ende (25) und ein zweites Ende (27) umfaßt, wobei das erste Ende (25) an das erste Ausgabeventil (4) und das zweite Ende (27) der ersten Ausgabevorleitung (26) an den ersten Abzugsweg oder eine erste Ausgabepumpe (28) gekoppelt ist.

2. Vorrichtung nach Anspruch 1, wobei das zweite Ende (27) der ersten Ausgabevorleitung (26) an den ersten Abzugsweg gekoppelt ist.

3. Vorrichtung nach Anspruch 1, wobei der erste Abzugsweg weiterhin eine erste Abzugspumpe (20), das erste Trennventil (24) und eine erste Abzugsvorleitung (22) umfaßt, wobei die erste Abzugspumpe (20) über die erste Abzugsvorleitung (22) an das erste Trennventil (24) gekoppelt ist.

4. Vorrichtung nach Anspruch 3, wobei der erste Abzugsweg von der Prozeßreaktorkammer (10) getrennt ist, wenn sich das erste Trennventil (24) in einem geschlossenen Zustand befindet.

5. Vorrichtung nach Anspruch 3, wobei das zweite Ende (27) der ersten Ausgabevorleitung (26) an das erste Trennventil (24) des ersten Abzugswegs gekoppelt ist.

6. Vorrichtung nach Anspruch 3, wobei das zweite Ende (27) der ersten Ausgabevorleitung (26) an die erste Abzugspumpe (20) des ersten Abzugswegs gekoppelt ist.

7. Vorrichtung nach Anspruch 3, wobei das zweite Ende (27) der ersten Ausgabevorleitung (22) an die erste Abzugsvorleitung (22) des ersten Abzugswegs gekoppelt ist.

8. Vorrichtung nach Anspruch 1, wobei die Vorrichtung weiterhin einen zweiten Abzugsweg umfaßt, der an einen zweiten Kammerauslaß (29) gekoppelt ist.

9. Vorrichtung nach Anspruch 8, wobei:
der erste Abzugsweg weiterhin eine erste Abzugspumpe (20), das erste Trennventil (24) und eine erste Abzugsvorleitung (22) umfaßt, wobei die erste Abzugspumpe (20) über die erste Abzugsvorleitung (22) an das erste Trennventil (24) gekoppelt ist; und
der zweite Abzugsweg weiterhin eine zweite Abzugspumpe (30), das zweite Trennventil (34) und eine zweite Abzugsvorleitung (32) umfaßt, wobei die zweite Abzugspumpe (30) über die zweite Abzugsvorleitung (32) an das zweite Trennventil (34) gekoppelt ist.

10. Vorrichtung nach Anspruch 8, wobei der zweite Abzugsweg von der Prozeßreaktorkammer (10) getrennt ist, wenn sich das Trennventil (34) in einem geschlossenen Zustand befindet.

11. Vorrichtung nach Anspruch 8, wobei das zweite Trennventil (34) direkt an den zweiten Kammerauslaß (29) der Prozeßreaktorkammer (10) gekoppelt ist, so daß zwischen dem zweiten Trennventil (34) und dem zweiten Kammerauslaß (29) keine wesentliche Abzugsvorleitung existiert.

12. Vorrichtung nach Anspruch 1, wobei das zweite Ende (27) der ersten Ausgabevorleitung (26) an die erste Ausgabepumpe (28) gekoppelt ist.

13. Vorrichtung nach Anspruch 1, wobei die Vorrichtung weiterhin eine zweite Ausgabevorleitung (36) umfaßt, die ein erstes Ende (31) und ein zweites Ende (33) umfaßt, wobei das erste Ende (31) an das zweite Ausgabeventil (8) und das zweite Ende (33) der zweiten Ausgabevorleitung (36) an einen zweiten Abzugsweg gekoppelt ist.

14. Vorrichtung nach Anspruch 13, wobei:
der erste Abzugsweg weiterhin eine erste Abzugspumpe (20), das erste Trennventil (24) und eine erste Abzugsvorleitung (22) umfaßt, wobei die erste Abzugspumpe (20) über die erste Abzugsvorleitung (22) an das erste Trennventil (24) gekoppelt ist; und
der zweite Abzugsweg weiterhin eine zweite Abzugspumpe (30), ein zweites Trennventil (34) und eine zweite Abzugsvorleitung (32) umfaßt, wobei die zweite Abzugspumpe (30) über die zweite Abzugsvorleitung (32) an das zweite Trennventil (34) gekoppelt ist.

15. Vorrichtung nach Anspruch 14, wobei das zweite Ende (33) der zweiten Ausgabevorleitung (36) an das zweite Trennventil (34) des zweiten Abzugswegs gekoppelt ist.

16. Vorrichtung nach Anspruch 14, wobei das zweite Ende (33) der zweiten Ausgabevorleitung (36) an die zweite Abzugspumpe (30) des zweiten Abzugswegs gekoppelt ist.

17. Vorrichtung nach Anspruch 14, wobei das zweite Ende (33) der zweiten Ausgabevorleitung (36) an die zweite Abzugsvorleitung (32) des zweiten Abzugswegs gekoppelt ist.

18. Vorrichtung nach Anspruch 12, wobei die Vorrichtung weiterhin eine zweite Ausgabevorleitung (36) umfaßt, die ein erstes Ende (31) und ein zweites Ende (33) umfaßt, wobei das erste Ende (31) an das zweite Ausgabeventil (8) und das zweite Ende (33) der zweiten Ausgabevorleitung (36) an eine zweite Ausgabepumpe gekoppelt ist.

19. Vorrichtung nach Anspruch 1, wobei die Vorrichtung weiterhin eine erste Dampfzufuhr umfaßt, die an den ersten Vorläufereinlaß (14) gekoppelt ist.

20. Vorrichtung nach Anspruch 19, wobei die Vorrichtung weiterhin eine zweite Dampfzufuhr umfaßt, die an den zweiten Vorläufereinlaß (16) gekoppelt ist.

21. Vorrichtung nach Anspruch 1, wobei der erste Vorläufereinlaß (14) und der zweite Vorläufereinlaß (16) sich eine gemeinsame Öffnung teilen.

22. Vorrichtung nach Anspruch 1, wobei der erste Vorläufereinlaß (14) und der zweite Vorläufereinlaß (16) getrennte Öffnungen aufweisen.

23. Vorrichtung nach Anspruch 1, wobei die Vorrichtung ein Reinigungsventil (7) umfaßt.

24. Vorrichtung nach Anspruch 1, wobei die Prozeßreaktor kammer (10) weiterhin eine Sprühköpfeinrichtung (18) enthält.

25. Atomlagenabscheidungsvorrichtung (2), die folgendes umfaßt:
eine Prozeßreaktorkammer (10);
ein erstes Trennventil (24), das direkt an einen ersten Kammerauslaß (17) der Prozeßreaktorkammer (10) gekoppelt ist, so daß zwischen dem ersten Trennventil (24) und dem ersten Kammerauslaß (17) keine wesentliche Abzugsvorleitung existiert;
eine erste Abzugspumpe (20), die durch eine erste Abzugsvorleitung (22) an das erste Trennventil (24) gekoppelt ist;
ein zweites Trennventil (34), das direkt an einen zweiten Kammerauslaß (29) der Prozeßreaktorkammer (10) gekoppelt ist, so daß zwischen dem zweiten Trennventil (34) und dem zweiten Kammerauslaß (29) keine wesentliche Abzugsvorleitung existiert; und
eine zweite Abzugspumpe (30), die durch eine zweite Abzugsvorleitung (32) an das zweite Trennventil (34) gekoppelt ist.

26. Prozeß zur Atomlagenabscheidung, der folgendes umfaßt:
Einleiten eines ersten Vorläufers in einen ersten Vorläufereinlaß (14) einer Prozeßreaktorkammer (10);
Steuern der Prozeßreaktorkammer (10) zur Absorption des ersten Vorläufers auf ein Substrat; Reinigen der Kammer (10) von nichtabsorbiertem erstem Vorläufer durch Öffnen eines direkt an einen Kammerauslaß gekoppelten Trennventils, so daß zwischen dem Trennventil und dem Kammerauslaß keine wesentliche Abzugsvorleitung existiert;
Einleiten eines zweiten Vorläufers in einem zweiten Vorläufereinlaß (16) der Prozeßreaktorkammer (10);
Steuern der Prozeßreaktorkammer (10) für eine Reaktion des zweiten Vorläufers mit dem ersten Vorläufer und
Reinigen der Prozeßreaktorkammer (10) von nichtumgesetztem zweitem Vorläufer durch Öffnen eines direkt an einen Kammerauslaß gekoppelten Trennventils, so daß zwischen dem Trennventil und dem Kammerauslaß keine wesentliche Abzugsvorleitung existiert.

27. Prozeß nach Anspruch 26, wobei:
die Prozeßreaktorkammer (10) von dem nichtabsorbierten ersten Vorläufer gereinigt wird durch Öffnen eines direkt an einen ersten Abzugsauslaß in der Reaktorkammer (10) gekoppelten erstes Trennventil (24) und
die Prozeßreaktorkammer (10) von nichtumgesetztem zweiten Vorläufer durch Öffnen eines direkt an einen zweiten Abzugsauslaß in der Reaktorkammer (10) gekoppelten Trennventils (34) gereinigt wird.

28. Atomlagenabscheidungsvorrichtung (2), die folgendes umfaßt:
eine Prozeßreaktorkammer (10), die einen ersten Vorläufereinlaß (14), einen zweiten Vorläufereinlaß (16) und einen ersten Kammerauslaß (17) umfaßt;
ein erstes Ausgabeventil (4), das an den ersten Vorläufereinlaß (14) der Prozeßreaktorkammer (10) gekoppelt ist;
ein zweites Ausgabeventil (8), das an den zweiten Vorläufereinlaß (16) der Prozeßreaktorkammer (10) gekoppelt ist;
einen ersten Abzugsweg, der an den ersten Kammerauslaß (17) der Prozeßreaktorkammer (10) gekoppelt und so konfiguriert ist, daß er selektiv von der Prozeßreaktorkammer (10) getrennt ist, wobei der erste Abzugsweg ein erstes Trennventil (24), eine ersten Abzugsvorleitung (22) und eine erste Abzugspumpe (20), die durch die erste Abzugsvorleitung (22) an das erste Trennventil (24) gekoppelt ist, umfaßt;
einen zweiten Abzugsweg, der an einen zweiten Kammerauslaß (29) der Prozeßreaktorkammer (10) gekoppelt und so konfiguriert ist, daß er selektiv von der Prozeßreaktorkammer (10) getrennt ist, wobei der zweite Abzugsweg ein zweites Trennventil (34), eine zweite Abzugsvorleitung (32) und eine zweite Abzugspumpe (30), die durch die zweite Abzugsvorleitung (32) an das zweite Trennventil (34) gekoppelt ist, umfaßt;
eine erste Ausgabevorleitung (26), die ein erstes Ende (25) und ein zweites Ende (27) umfaßt, wobei das erste Ende (25) an das erste Ausgabeventil (4) und das zweite Ende (27) der ersten Ausgabevorleitung (26) an den ersten Abzugsweg (22) oder eine erste Ausgabepumpe (20) gekoppelt ist; und
eine zweite Ausgabevorleitung (36), die ein erstes Ende (31) und ein zweites Ende (33) umfaßt, wobei das erste Ende (31) an das zweite Ausgabeventil (8) und das zweite Ende (33) der zweiten Ausgabevorleitung (36) an den zweiten Abzugsweg oder eine zweite Ausgabepumpe gekoppelt ist.

## Revendications

1. Appareil de dépôt par couche atomique (2) comprenant :
une chambre de réacteur de traitement (10) comprenant une première entrée de précurseur (14), une seconde entrée de précurseur (16), et une première sortie de chambre (17) ;
une première soupape de distribution (4) couplée à ladite première entrée de précurseur (14) de ladite chambre du réacteur de traitement (10) ;
une seconde soupape de distribution (8) couplée à ladite seconde entrée de précurseur (16) de ladite chambre du réacteur de traitement (10) ;
un premier trajet d'évacuation couplé à ladite chambre du réacteur de traitement (10) configuré pour être isolé sélectivement de ladite chambre du réacteur de traitement (10) par une première soupape d'isolation (24) directement couplée à. ladite sortie de chambre (17) de telle sorte qu'aucune ligne avant d'évacuation substantielle n'existe entre ladite soupape d'isolation (24) et ladite sortie de chambre (17) ; et
une première ligne avant de distribution (26) comprenant une première extrémité (25) et une seconde extrémité (27), dans laquelle ladite première extrémité (25) est couplée à ladite première soupape de distribution (4) et ladite seconde extrémité (27) de ladite première ligne avant de distribution (26) est couplée au dit premier chemin d'évacuation ou à une première pompe de distribution (28).

2. Appareil selon la revendication 1, dans lequel ladite seconde extrémité (27) de ladite première ligne avant de distribution (26) est couplée au dit premier chemin d'évacuation.

3. Appareil selon la revendication 1, dans lequel ledit premier chemin d'évacuation comprend également une première pompe d'évacuation (20), ladite première soupape d'isolation (24), et une première ligne avant d'évacuation (22), dans lequel ladite première pompe d'évacuation (20) est couplée à ladite première soupape d'isolation (24) par ladite première ligne avant d'évacuation (22).

4. Appareil selon la revendication 3, dans lequel ledit premier chemin d'évacuation est isolé de ladite chambre du réacteur de traitement (10) quand ladite première soupape d'isolation (24) est dans un état fermé.

5. Appareil selon la revendication 3, dans lequel ladite seconde extrémité (27) de ladite première ligne avant de distribution (26) est couplée à ladite première soupape d'isolation (24) dudit premier chemin d'évacuation.

6. Appareil selon la revendication 3, dans lequel ladite seconde extrémité (27) de ladite première ligne avant de distribution (26) est couplée à ladite première pompe d'évacuation (20) dudit premier chemin d'évacuation.

7. Appareil selon la revendication 3, dans lequel ladite seconde extrémité (27) de ladite première ligne avant de distribution (26) est couplée à ladite première ligne avant d'évacuation (22) dudit premier chemin d'évacuation.

8. Appareil selon la revendication 1, dans lequel ledit appareil comprend également un second chemin d'évacuation couplé à une seconde sortie de chambre (29).

9. Appareil selon la revendication 8, dans lequel :
ledit premier chemin d'évacuation comprend une première pompe d'évacuation (20), ladite première soupape d'isolation (24), et une première ligne avant d'évacuation (22), dans lequel ladite première pompe d'évacuation (20) est couplée à ladite première soupape d'isolation (24) par ladite première ligne avant d'évacuation (22) ; et
ledit second chemin d'évacuation comprend une seconde pompe d'évacuation (30), une seconde soupape d'isolation (34), et une seconde ligne avant d'évacuation (32), dans lequel ladite seconde pompe d'évacuation (30) est couplée à ladite seconde soupape d'isolation (34) par ladite seconde ligne avant d'évacuation (32).

10. Appareil selon la revendication 8, dans lequel ledit second chemin d'évacuation est isolé de ladite chambre du réacteur de traitement (10) quand ladite soupape d'isolation (34) est dans un état fermé.

11. Appareil selon la revendication 8, dans lequel ladite seconde soupape d'isolation (34) est directement couplée à ladite seconde sortie de chambre (29) de ladite chambre du réacteur de traitement (10) de telle sorte qu'aucune ligne avant d'évacuation substantielle n'existe entre ladite seconde soupape d'isolation (34) et ladite seconde sortie de chambre (29).

12. Appareil selon la revendication 1, dans lequel ladite seconde extrémité (27) de ladite première ligne avant de distribution (26) est couplée à ladite première pompe de distribution (28).

13. Appareil selon la revendication 1, dans lequel ledit appareil comprend également une seconde ligne avant de distribution (36) comprenant une première extrémité (31) et une seconde extrémité (33), dans laquelle ladite première extrémité (31) est couplée à ladite seconde soupape de distribution (8) et ladite seconde extrémité (33) de ladite seconde ligne avant de distribution (36) est couplée à un second chemin d'évacuation.

14. Appareil selon la revendication 13, dans lequel :
ledit premier chemin d'évacuation comprend une première pompe d'échappement (20), ladite première soupape d'isolation (24), et une première ligne avant d'évacuation (22), dans lequel ladite première pompe d'évacuation (20) est couplée à ladite première soupape d'isolation (24) par ladite première ligne avant d'évacuation (22) ; et
ledit second chemin d'évacuation comprend une seconde pompe d'évacuation (30), une seconde soupape d'isolation (34), et une seconde ligne avant d'évacuation (32), dans lequel ladite seconde pompe d'évacuation (30) est couplée à ladite seconde soupape d'isolation (34) par ladite seconde ligne avant d'évacuation (32).

15. Appareil selon la revendication 14, dans lequel ladite seconde extrémité (33) de ladite seconde ligne avant de distribution (36) est couplée à ladite seconde soupape d'isolation (34) dudit second chemin d'évacuation.

16. Appareil selon la revendication 14, dans lequel ladite seconde extrémité (33) de ladite seconde ligne avant de distribution (36) est couplée à ladite seconde pompe d'évacuation (30) dudit second chemin d'évacuation.

17. Appareil selon la revendication 14, dans lequel ladite seconde extrémité (33) de ladite seconde ligne avant de distribution (36) est couplée à ladite seconde ligne avant d'évacuation (32) dudit second chemin d'évacuation.

18. Appareil selon la revendication 12, dans lequel ledit appareil comprend également une seconde ligne avant de distribution (36) comprenant une première extrémité (31) et une seconde extrémité (33), dans laquelle ladite première extrémité (31) est couplée à ladite seconde soupape de distribution (8) et ladite seconde extrémité (33) de ladite seconde ligne avant de distribution (36) est couplée à une seconde pompe de distribution.

19. Appareil selon la revendication 1, dans lequel ledit appareil comprend également une première alimentation de vapeur couplée à ladite première entrée de précurseur (14).

20. Appareil selon la revendication 19, dans lequel ledit appareil comprend également une seconde alimentation de vapeur couplée à ladite seconde entrée de précurseur (16).

21. Appareil selon la revendication 1, dans lequel ladite première entrée de précurseur (14) et ladite seconde entrée de précurseur (16) partagent une ouverture commune.

22. Appareil selon la revendication 1, dans lequel ladite première entrée de précurseur (14) et ladite seconde entrée de précurseur (16) ont des ouvertures séparées.

23. Appareil selon la revendication 1, dans lequel ledit appareil comprend une soupape de purge (7).

24. Appareil selon la revendication 1, dans lequel ladite chambre du réacteur de traitement (10) comprend également un dispositif de pomme de douche (18).

25. Appareil de dépôt par couche atomique (2) comprenant
une chambre de réacteur de traitement (10) ;
une première soupape d'isolation (24) directement couplée à une première sortie de chambre (17) de ladite chambre du réacteur de traitement (10) de telle sorte qu'aucune ligne avant d'évacuation substantielle n'existe entre ladite première soupape d'isolation (24) et ladite première sortie de chambre (17) ;
une première pompe d'évacuation (20) couplée à ladite première soupape d'isolation (24) par une première ligne avant d'évacuation (22) ;
une seconde soupape d'isolation (34) directement couplée à une seconde sortie de chambre (29) de ladite chambre du réacteur de traitement (10) de telle sorte qu'aucune ligne avant d'évacuation substantielle n'existe entre ladite seconde soupape d'isolation (34) et ladite seconde sortie de chambre (29) ; et
une seconde pompe d'évacuation (30) couplée à ladite seconde soupape d'isolation (34) par une seconde ligne avant d'évacuation (32).

26. Procédé pour le dépôt par couche atomique comprenant
l'introduction d'un premier précurseur dans une première entrée de précurseur (14) d'une chambre du réacteur de traitement (10) ;
le contrôle de ladite chambre du réacteur de traitement (10) pour l'absorption dudit premier précurseur sur un substrat ;
la purge de ladite chambre (10) du premier précurseur non absorbé en ouvrant une soupape d'isolation directement couplée à une sortie de chambre de telle sorte qu'aucune ligne avant d'évacuation substantielle n'existe entre ladite soupape d'isolation et ladite sortie de chambre ;
l'introduction d'un second précurseur dans une seconde entrée de précurseur (16) de ladite chambre du réacteur de traitement (10) ;
le contrôle de ladite chambre du réacteur de traitement (10) pour la réaction dudit second précurseur avec ledit premier précurseur ; et
la purge de ladite chambre du réacteur de traitement (10) du second précurseur non réagi en ouvrant une soupape d'isolation directement couplée à une sortie de chambre de telle sorte qu'aucune ligne avant d'évacuation substantielle n'existe entre ladite soupape d'isolation et ladite sortie de chambre.

27. Procédé selon la revendication 26, dans lequel :
ladite chambre du réacteur de traitement (10) est purgée dudit premier précurseur non absorbé en ouvrant une première soupape d'isolation (24) directement couplée à une première sortie d'évacuation dans ladite chambre du réacteur (10) ; et
ladite chambre du réacteur de traitement (10) est purgée dudit second précurseur non réagi en ouvrant une seconde soupape d'isolation (34) directement couplée à une seconde sortie d'évacuation dans ladite chambre du réacteur (10).

28. Appareil de dépôt par couche atomique (2) comprenant
une chambre de réacteur de traitement (10) comprenant une première entrée de précurseur (14), une seconde entrée de précurseur (16), et une première sortie de chambre (17) ;
une première soupape de distribution (4) couplée à ladite première entrée de précurseur (14) de ladite chambre du réacteur de traitement (10) ;
une seconde soupape de distribution (8) couplée à ladite seconde entrée de précurseur (16) de ladite chambre du réacteur de traitement (10) ;
un premier chemin d'évacuation couplé à ladite première sortie de chambre (17) de ladite chambre du réacteur de traitement (10) et configuré pour être isolé sélectivement de ladite chambre du réacteur de traitement (10), dans lequel ledit premier chemin d'évacuation comprend une première soupape d'isolation (24), une première ligne avant d'évacuation (22), et une première pompe d'évacuation (20) couplée à ladite première soupape d'isolation (24) par ladite première ligne avant d'évacuation (22) ;
un second chemin d'évacuation couplé à une seconde sortie de chambre (29) de ladite chambre du réacteur de traitement (10) et configuré pour être isolé sélectivement de ladite chambre du réacteur de traitement (10), dans lequel ledit second chemin d'évacuation comprend une seconde soupape d'isolation (34), une seconde ligne avant d'évacuation (32), et une seconde pompe d'évacuation (30) couplée à ladite seconde soupape d'isolation (34) par ladite seconde ligne avant d'évacuation (32) ;
une première ligne avant de distribution (26) comprenant une première extrémité (25) et une seconde extrémité (27), dans laquelle ladite première extrémité (25) est couplée à ladite première soupape de distribution (4) et ladite seconde extrémité (27) de ladite première ligne avant de distribution (26) est couplée au dit premier chemin d'évacuation (22) ou à une première pompe de distribution (20) ; et
une seconde ligne avant de distribution (36) comprenant une première extrémité (31) et une seconde extrémité (33), dans laquelle ladite première extrémité (31) est couplée à ladite seconde soupape de distribution (8) et ladite seconde extrémité (33) de ladite seconde ligne avant de distribution (36) est couplée au dit second chemin d'évacuation ou à une seconde pompe de distribution.
